# EUROPEAN PATENT APPLICATION

(11) **EP 3 761 358 A1**
(43) Date of publication of application: **06.01.2021**
(21) Application number: 19183927.3
(22) Date of filing: 02.07.2019
(51) Int. Cl.: H01L 23/495

(54) **A LEAD FRAME ASSEMBLY FOR A SEMICONDUCTOR DEVICE**

(71) Applicant: Nexperia B.V., 6534 AB Nijmegen (NL)
(72) Inventor: Yandoc, Ricardo, 6534 AB Nijmegen (NL); Brown, Adam, 6534 AB Nijmegen (NL); Bernhardt, Dirk, 6534 AB Nijmegen (NL)
(74) Representative: Pjanovic, Ilija

(57) **Abstract**

This disclosure relates to a lead frame assembly for a semiconductor device and a method of manufacturing a semiconductor device comprising such a lead frame assembly. The lead frame assembly comprises the lead frame assembly comprising: a clip member and a lead member having opposing surfaces; the lead member comprising a recess portion arranged on the opposing surface thereof, and wherein the clip member is fixedly and electrically attached to said lead member at the opposing surface thereof by said solder material at said recess portion.

## Description

### FIELD

The present disclosure relates to a lead frame assembly for a semiconductor device. In particular the present disclosure relates to a clip based lead frame assembly for a semiconductor device and a method of manufacturing a semiconductor device.

### BACKGROUND

Semiconductor device packages such as SOD123W and SOD128, use so-called clips to provide external electrical connections from the terminals on the semiconductor die to the external leads. Clip based packages typically have improved electrical, mechanical and thermal performance when compared to packages using more conventional wire based, so-called wire bond, connections.

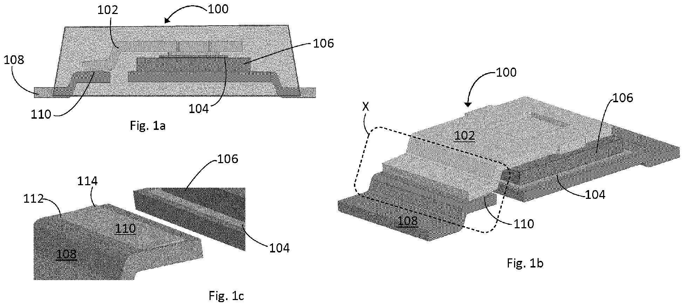

Whilst clip based packages have improved reliability and performance when compared to wire bond arrangements, they can suffer from issues related to consistent manufacturability and operational reliability. For example, at one end the clips are typically attached to the terminals of the semiconductor dies using a solder material. At an opposite end the clips may also be attached to the external lead using a solder material. A process known as solder reflow is then carried out to form the connections of the clip to the terminals of the semiconductor packages and to the external lead. A known typical arrangement for a semiconductor device package is shown in Figures 1a to 1c.

With reference to Figures 1a to 1c, the known arrangement of semiconductor device package 100 includes a clip member 102 connected, at a first portion, to a contact 104 arranged on a top side of a semiconductor die 106. The clip member 102 is connected, at a second portion distal the first portion, to a lead member 108. The lead member 108 forms the external connections of the semiconductor device 100 for connection to, for example, a printed circuit board (PCB), not illustrated. The clip member 102 is electrically and mechanically attached to the lead member 108 by a solder connection 110.

A solder contact surface of the clip member 102 may angled, that is not parallel, with respect to a solder contact surface of the lead member 108 and this angle can occur in a number of ways. The clip member 102 may be angled as it meets the lead member 108 and this can be advantageous in that it allows for greater control of the contact between the clip member 102 and the top contact 104 of the semiconductor die 106. Alternatively, clip member may be designed to be parallel as it meets the lead member 108 but may become angled with respect to the lead portion during solder reflow due to gravity and/or capillary force effects caused by the molten solder. In any event it is difficult to mount the clip member 102 to the lead member 108 such that it is not angled. This angle will therefore result in a solder connection 110 which is also angled, that is the angle of the solder connection 110 will follow the angle between the clip member 102 and the lead member 108. Furthermore, if the clip member 102 mounted on the lead member 108 is parallel, this may result in a solder joint which is not thick enough to withstand thermal cycling effects, discussed below, during operation.

As illustrated more clearly in Figure 1c, which shows a close up of area X of Figure 1b, of the solder connection 110, with the clip member 102 removed for ease of illustration. The solder connection 110 has a thin portion 112 extending towards a thick portion 114. In other words the solder connection 110 will be substantially wedge shaped so as to follow the angle between the clip member 102 and the lead member 108.

The above described angled clip member 102 design may result in degradation of the solder, in particular at the thin portion 112 of the solder connection 110. Heating effects can occur during operation of a semiconductor device. As the semiconductor device is continuously switched on and off, the device and consequently the lead frame assembly and solder connection will heat up and cool down. This heating up and cooling down, known as temperature cycling, can cause the solder and the clip and lead members to expand and contract. Due to differences in the coefficient of thermal expansion between the solder, which is the weakest point, and the clip and lead members, the solder can be subjected to thermally induced stresses and cause thin solder connection portions to crack and degrade. This can ultimately result in failure of the semiconductor device.

### SUMMARY

Various example embodiments are directed to issues such as those addressed above and/or others which may become apparent from the following disclosure concerning improving solder connections between clip members and lead members for semiconductor device packages.

In certain example embodiments, aspects of the present disclosure involve providing consistent solder connections between clip members and lead members for semiconductor device packages.

According to an embodiment there is provided a lead frame assembly for a semiconductor device, the lead frame assembly comprising: a clip member and a lead member having opposing surfaces; the lead member comprising a recess portion arranged on the opposing surface thereof, and wherein the clip member is fixedly and electrically attached to said lead member at the opposing surface thereof by said solder material at said recess portion.

The clip member may comprise a semiconductor die attach portion and a lead member attach portion and said recess portion is provided on said lead member attach portion.

The recess portion having an internal height and wherein the internal height may be up to 50% of the thickness of the lead member attach portion.

The lead frame assembly may further comprise a first hole extending through the clip member, wherein the first hole is located intermediate the die attach portion and the lead member attach portion.

The lead frame assembly may further comprise a second hole extending through the clip member, wherein the second hole is located at the die attach portion.

The recess portion may be substantially rectangular in shape. The recess portion may be substantially in square shape. The recess portion may be substantially circular in shape.

According to an embodiment there is also provided a method of manufacturing a semiconductor device, the method comprising: providing a clip member and a lead member having opposing surfaces; forming a recess portion on the opposing surface of the lead member, wherein the recess portion is configured and arranged to receive a solder material; and fixedly and electrically attaching the clip member to said lead member at the opposing surface thereof by said solder material at said recess portion.

The clip member may comprise a semiconductor die attach portion and a lead member attach portion and forming said recess portion on said lead member attach portion.

The recess portion may have an internal height and wherein the internal height is formed up to 50% of the thickness of the lead member attach portion.

The method may further comprise forming a first hole extending through the clip member, wherein the first hole is formed at a location intermediate the die attach portion and the lead member attach portion.

The method may further comprise forming a second hole extending through the clip member, wherein the second hole is formed at the die attach portion.

There is also provided a semiconductor device comprising the lead frame assembly according to embodiments.

### DESCRIPTION OF THE DRAWINGS

So that the manner in which the features of the present disclosure can be understood in detail, a more particular description is made with reference to embodiments, some of which are illustrated in the appended figures. It is to be noted, however, that the appended figures illustrate only typical embodiments and are therefore not to be considered limiting of its scope. The figures are for facilitating an understanding of the disclosure and thus are not necessarily drawn to scale. Advantages of the subject matter claimed will become apparent to those skilled in the art upon reading this description in conjunction with the accompanying figures, in which like reference numerals have been used to designate like elements, and in which:
Figure 1a shows a side view of a known arrangement of semiconductor device package using a clip member;
Figure 1b shows a perspective view of a known arrangement of semiconductor device package using a clip member;
Figure 1c shows a close up perspective view, with clip removed, of area X of Figure 1b of a known arrangement of semiconductor device package;
Figure 2a illustrates side view of a semiconductor device package according to embodiments;
Figure 2b illustrates a perspective view of a semiconductor device package according to embodiments;
Figure 2c illustrates a close up perspective view, with clip member removed, of area X of Figure 2b of a semiconductor device according to embodiments;
Figure 2d illustrates a close up perspective view of a semiconductor device according to embodiments;
Figure 3a illustrates top view of a semiconductor device package according to embodiments;
Figure 3b illustrates a perspective view of a semiconductor device package according to embodiments;
Figure 3c illustrates a close up perspective view, with clip member removed, of area X of Figure 3b of a semiconductor device according to embodiments;
Figure 3d illustrates a close up perspective view of a semiconductor device according to embodiments;
Figure 4 illustrates a perspective view of a semiconductor device package according to embodiments;
Figure 5 illustrates a perspective view of a semiconductor device package according to embodiments; and
Figure 6 illustrates a perspective view of a semiconductor device package according to embodiments.

### DETAILED DESCRIPTION

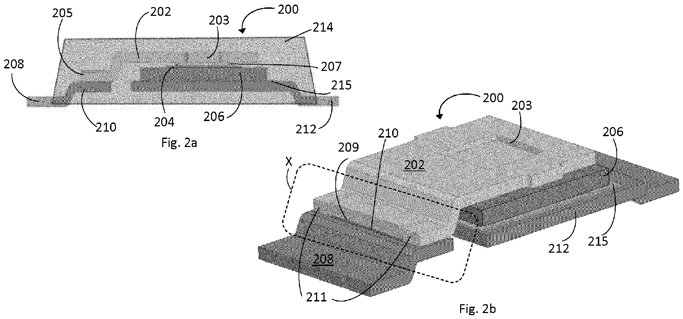

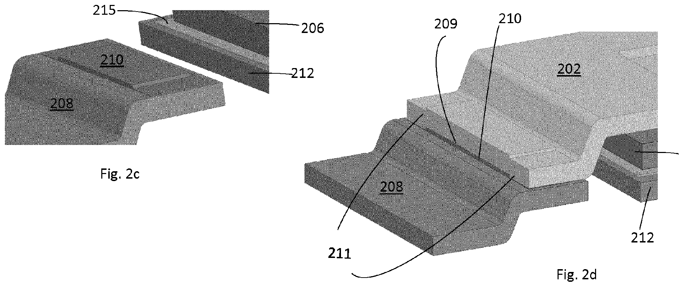

Figure 2a illustrates a side view of a semiconductor device package 200 comprising the lead frame assembly according to embodiments. For the purposes of explanation Figure 2a shows the outline of the semiconductor device package 200 encapsulation material 214, however, for brevity and ease of illustration the encapsulation material 214 has been omitted from Figures 2b, 2c and 2d.

As illustrated in Figures 2a and 2b, the semiconductor device package 200 comprises a lead frame assembly, where the lead frame assembly includes a clip member 202, a lead member 208 and a die attach portion 212. The clip member 202 is connected, at a first portion 203, to a top contact 204 arranged on a top side of a semiconductor die 206. The clip member 202 is connected, at a second portion 205 distal the first portion 203, to the lead member 208. The lead member 208 forms the external connection(s) of the semiconductor device 200 for connection to, for example, a PCB or other suitable carrier (not illustrated). The clip member 202 is electrically and mechanically attached to the lead member 208 by a solder connection 210.

The first portion 203 of the clip member 202 is arranged as a down stand 207 and is arranged to extends away from the first portion 203 towards and onto the top contact 204 of the semiconductor die 206. Whilst not illustrated, the down stand 207 may be electrically and mechanically connected to the top contact 204 by a solder connection or other suitable conductive adhesive.

The second portion 205 of the clip member 202, comprises an upstand or recessed portion 209, arranged in a bottom surface of the second portion 205. In other words the bottom surface of the second portion 205, that is the surface designed to be connected to the lead member 208 by the solder connection 210, is recessed. This recessed portion 209 allows the second portion 205 of the clip member 202 to receive the solder material and form the solder connection 210 to the lead member 208. Side portions 211 of the second portion 205 of the clip 202 member may also be connected to the lead member 208 by the solder connection 210. However, the skilled person will appreciate that since the side portions 211 do not contain a recess portion, the thickness of the solder connection 210 will be thinner than the solder connection 210 at the recess portion 209. This thickness differential can be seen more clearly in Figures 2c and 2d, where the thickness of the solder connection 210 directly under the recessed portion 209 is greater than the thickness of the solder connection 210 outside the area of the recessed portion 209. Due to the consistent thickness of the solder connection 210 under the recessed portion 209, the thinner solder connection portion outside the area of the recessed portion 209 may degrade during operation, however this will not affect operation of the semiconductor device due to the thicker portion of the solder connection 210 under the recessed portion 209.

The arrangement of the recessed portion 209 when mounted the lead member 208 will result in a solder connection 210 thickness which is at least as thick as the internal height of the recessed portion 209 because the solder material forming the solder connection 210 will fill the volume of the recess portion during solder reflow. This will therefore result in a solder connection 210 under the recessed portion 209 without thin portions and which has a consistent minimum thickness. For example, the internal height of the recessed portion may be up to 50% of the thickness of the clip member 202 as it connects to the lead member. This thickness will be dictated by stamping or etching processes to form the recess portion 209, without damaging the clip member 202. In absolute terms, and by way of example only, the clip member may have a thickness of 10µm such that the internal height of the recessed portion may be 5µm. This will result in a minimum 5µm thick solder connection 210 under the recessed portion which ensures that the solder connection 210 does not degrade during operation of the semiconductor device. Typically, and dependent on the type of semiconductor device (that is high power or low power), the internal height of the recessed portion may be 1µm resulting in a solder connection 210 thickness of 1µm. Any less than 1µm and the solder connection may degrade due to thermal cycling, as discussed above. The maximum thickness of the solder connection may be 40µm. Any greater than 40µm and accurate positioning of the clip member on the lead member may be difficult

A bottom surface of the semiconductor die 206 is mounted on the die attach portion 212. The bottom surface of the semiconductor die 206 may comprise a bottom contact (not illustrated) which is electrically and mechanically contacted to the die attach portion 212.

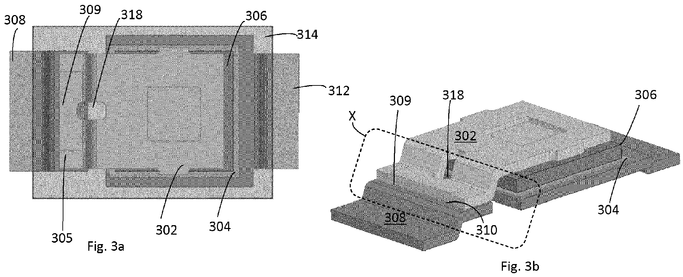

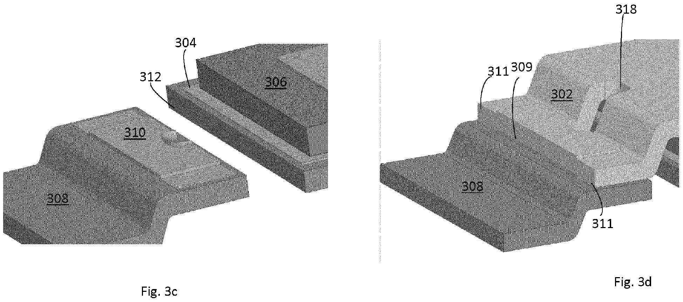

Figures 3a illustrates a side view of a semiconductor device package 300 comprising a lead frame assembly according to embodiments. For the purposes of explanation Figure 3a shows the outline of the semiconductor device package 300 encapsulation material 314, however, for brevity and clarity the encapsulation has been omitted from Figures 3b, 3c and 3d.

As illustrated in Figures 3a and 3b, the semiconductor device package 300 comprises a lead frame assembly, where the lead frame assembly includes a clip member 302 and a lead member 308 and a die attach portion 312. The clip member 302 is connected, at a first portion 303, to a contact 304 arranged on a top side of a semiconductor die 306. The clip member 302 is connected, at a second portion 305 distal the first portion 303, to the lead member 308. The lead member 308 forms the external connection(s) of the semiconductor device 100 for connection to, for example, a PCB or other suitable carrier (not illustrated). The clip member 302 is electrically and mechanically attached to the lead member 308 by a solder connection 310.

The first portion 303 of the clip member 302 is arranged as a down stand 307 and is arranged to extends away from the first portion 303 towards and onto the top contact 304 of the semiconductor die 306. Whilst not illustrated, the down stand 307 may be electrically and mechanically connected to the top contact 304 by a solder connection or other suitable conductive adhesive.

The second portion 305 of the clip member 302, comprises an upstand or recessed portion 309, arranged in a bottom surface of the second portion 305. In other words the bottom surface of the second portion, that is the surface designed to be connected to the lead member 308 by the solder connection 310, is recessed. This recessed portion 309 allows the second portion 305 of the clip member 302 to receive the solder material and form the solder connection 310 to the lead member 308. Side portions 311 of the second portion 305 of the clip 302 member may also be connected to the lead member 308 by a solder material. However, the skilled person will appreciate that since the side portions 311 do not contain a recess portion, the thickness of the solder connection will be thinner than the solder connection 310 at the recess portion 209. This thickness differential can be seen more clearly in Figures 3c and 3d, where the thickness of the solder connection 310 directly under the recessed portion 309 is greater than the thickness of the solder connection 310 under the side portions 311. As with the embodiment of Figures 2a to 2d, due to the consistent thickness of the solder connection 310 under the recessed portion 309, the thinner solder connection portion outside the area of the recessed portion 309 may degrade during operation, however this will not affect operation of the semiconductor device due to the thicker portion of the solder connection 310 under the recessed portion 309.

Furthermore, as with the arrangement of Figures 2a to 2d the arrangement of the recessed portion 309 when mounted the lead member 308 will result in a solder connection 310 thickness which is at least as thick as the internal height of the recessed portion 309 because the solder material forming the solder connection 310 will fill the volume of the recess portion during solder reflow. This will therefore result in a solder connection 310 under the recessed portion 309 without thin portions and which has a consistent minimum thickness.

A bottom surface of the semiconductor die 306 is mounted on the die attach portion 312. The bottom surface of the semiconductor die 306 may comprise a bottom contact (not illustrated) which is electrically contacted to the die attach portion.

A first outgassing hole or slot 318 may also be provided in the clip member 302, located adjacent the second portion 305 and between the second portion 305 and the first portion 303. The first outgassing hole 318 allows for venting of gasses generated during the solder reflow process, as discussed in more detail below. The first outgassing hole 318 allow reflow gasses to be released thereby preventing a build-up of gaseous pressure under the clip member 302 which may have the effect of forcing the clip member 302 upwards such that it is misaligned with both the lead member 308 and the contact 304 on the top side of the semiconductor die 306. The location of the first outgassing hole 318 is such that it may extend partially into the recess portion 309 to assist in outgassing during formation of the solder connection 310 between the clip member 302 and the lead member 308. Furthermore the first outgassing hole 318 may reduce stresses caused by the coefficient of thermal expansion difference between mould material in the finally packaged semiconductor device, as discussed below, and the clip member 302.

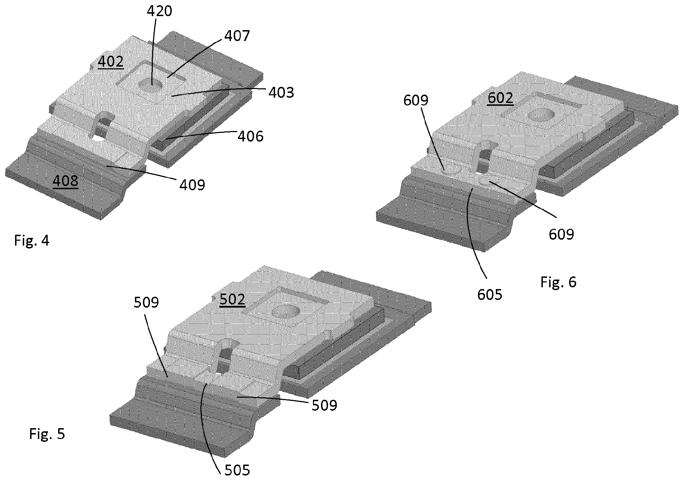

With reference to Figure 4, a second outgassing hole 420 may also be provided in the clip member 402 located at the first portion 403. The second out gassing hole 420 is formed through the down stand portion 407 and is configured and arranged to allow reflow gasses generated during reflow of the solder connection to the top contact of the semiconductor die 406 to be released, thereby preventing a build-up of gaseous pressure under the clip member 402.

With reference to the arrangement of Figures 2a, 3a and 4 a single recessed portion 209, 309, 409 may be provided. However, the skilled person will appreciate that a plurality of recessed portions 209, 309, 409 may be provided as illustrated for example in the arrangements Figure 5 and Figure 6.

As illustrated in the arrangement of Figure 5, a plurality of substantially square recess portions 509 are arranged spaced apart on the second portion 505 of the clip member 502. Likewise, in the arrangement of Figure 6 a plurality of substantially circular recess portions 609 are arranged spaced apart on the second portion 605 of the clip member 602.

The various process steps for manufacturing the semiconductor device 200 in accordance with an embodiment will be described with reference to the embodiment of Figures 2a to 2d.

A die attach portion 212 with a plurality of lead portions extending therefrom is provided. The die attach portion 212 and lead portions may be formed of any appropriate conductive material such as copper.

In the next step a die attach material 215 is dispensed onto the die attach portion 212. The die attach material 215 is arranged for fixedly mounting the semiconductor die 206 to the die attach portion 212. The die attach material 215 may be any appropriate adhesive material such as a solder or conductive adhesive.

In addition, the clip member attachment material 210 (which may be a solder material) may be dispensed onto the lead member 208. The clip member attachment material 210 may be arranged to fixedly mount the clip member 202 to the lead portion 208.

Dispensing of the die attach material 215 may be carried out simultaneously with the dispensing of the clip member attachment material 210. Optionally the die attach material 215 may be formed of the same material as the clip member attachment material 210.

Following dispensing of the die attach material 215 and the clip attach material the clip member attachment material 210, the semiconductor die 206 is attached to the die attach portion 212 of the lead frame assembly. Following placement of the semiconductor die 206, a contact terminal attach material is dispended on the top side contact of the semiconductor die 206 for electrical and mechanical connection of the clip member 202 to the semiconductor die 206. The die attach material may be applied by any appropriate process such as solder printing or solder dispense.

Once the semiconductor die 206 is in place on the die attach portion 212, the contact terminal attach material is arranged on the top contact of the semiconductor die 206. The clip member 202 may then be arranged on the contact terminals and on the lead member 208 as illustrated in the side view of Figure 2a.

Following the attachment of the clip member 202 to the contact of the semiconductor die 206 and the lead portion 208 the assembly undergoes solder re-flow to solidify the clip member attachment material 210 , the contact terminal attach material and the die attach material 215. In the arrangement of Figures 3a to 3d and Figure 4, gasses generated between the clip member and the lead portion, and the clip member and the semiconductor die during the reflow process may be vented by respective outgassing holes 318, 420 provided in the clip member.

Following reflow, the assembly may then be packaged, in a mould material 214, 314 as illustrated in outline in Figure 2a and 3a.

Particular and preferred aspects of the invention are set out in the accompanying independent claims. Combinations of features from the dependent and/or independent claims may be combined as appropriate and not merely as set out in the claims.

The scope of the present disclosure includes any novel feature or combination of features disclosed therein either explicitly or implicitly or any generalisation thereof irrespective of whether or not it relates to the claimed invention or mitigate against any or all of the problems addressed by the present invention. The applicant hereby gives notice that new claims may be formulated to such features during prosecution of this application or of any such further application derived therefrom. In particular, with reference to the appended claims, features from dependent claims may be combined with those of the independent claims and features from respective independent claims may be combined in any appropriate manner and not merely in specific combinations enumerated in the claims.

Features which are described in the context of separate embodiments may also be provided in combination in a single embodiment. Conversely, various features which are, for brevity, described in the context of a single embodiment, may also be provided separately or in any suitable sub combination.

Term "comprising" does not exclude other elements or steps, the term "a" or "an" does not exclude a plurality. Reference signs in the claims shall not be construed as limiting the scope of the claims.

## Claims

1. A lead frame assembly for a semiconductor device, the lead frame assembly comprising:
a clip member and a lead member having opposing surfaces;
the lead member comprising a recess portion arranged on the opposing surface thereof, and wherein the clip member is fixedly and electrically attached to said lead member at the opposing surface thereof by said solder material at said recess portion.

2. The lead frame assembly of claim 1, wherein the clip member comprises a semiconductor die attach portion and a lead member attach portion and said recess portion is provided on said lead member attach portion.

3. The lead frame assembly of claims 1 or 2, the recess portion having an internal height and wherein the internal height is up to 50% of the thickness of the lead member attach portion.

4. The lead frame assembly of claims 1 to 3, further comprising a first hole extending through the clip member, wherein the first hole is located intermediate the die attach portion and the lead member attach portion.

5. The lead frame assembly of claim 1 to 4, further comprising a second hole extending through the clip member, wherein the second hole is located at the die attach portion.

6. The leadframe assembly of any preceding claim, wherein the recess portion is substantially rectangular in shape.

7. The leadframe assembly of any preceding claim, wherein the recess portion is substantially in square shape.

8. The lead frame assembly of any preceding claim wherein the recess portion have a substantially circular in shape.

9. A method of manufacturing a semiconductor device, the method comprising: providing a clip member and a lead member having opposing surfaces;
forming a recess portion on the opposing surface of the lead member, wherein the recess portion is configured and arranged to receive a solder material; and
fixedly and electrically attaching the clip member to said lead member at the opposing surface thereof by said solder material at said recess portion.

10. The method of claim 9, wherein the clip member comprises a semiconductor die attach portion and a lead member attach portion and forming said recess portion on said lead member attach portion.

11. The method of claim 9 or 10, the recess portion having an internal height and wherein the internal height is formed up to 50% of the thickness of the lead member attach portion.

12. The method of claims 9 to 11, further comprising forming a first hole extending through the clip member, wherein the first hole is formed at a location intermediate the die attach portion and the lead member attach portion.

13. The method of claim 9 to 12, further comprising forming a second hole extending through the clip member, wherein the second hole is formed at the die attach portion.

14. The method of claims 9 to 13, wherein the recess portion is substantially rectangular in shape.

15. A semiconductor device comprising the lead frame assembly of any of claims 1 to 8.
